# FASCICULE DE BREVET EUROPEEN

(11) **EP 1 124 408 B1**
(45) Date de publication et mention de la délivrance du brevet: **06.07.2005**
(21) Numéro de dépôt: 01400342.0
(22) Date de dépôt: 09.02.2001
(51) Int. Cl.: H05K 7/14, H02K 11/04

(54) **Convertisseur pour machine électrique**
Konverter für elektrische Maschine
Converter for electrical machine

(30) Priorité: 11.02.2000 FR 0001747
(43) Date de publication de la demande: 16.08.2001
(73) Titulaire: MOTEURS LEROY-SOMER, 16000 Angouleme (FR)
(72) Inventeur: Petit, Serge, 16440 Roullet (FR); Petillon, Jean-Marc, 16730 Fleac (FR); Buisson, Alain, 69126 Brindas (FR); Giraud, Régis, 16000 Angouleme (FR)
(74) Mandataire: Tanty, François

(56) Documents cités:
- DE-A- 19 744 422
- FR-A- 1 289 102
- FR-A- 2 153 307
- PATENT ABSTRACTS OF JAPAN vol. 1996, no. 03, 29 mars 1996 (1996-03-29) & JP 07 298555 A (FUJI ELECTRIC CO LTD), 10 novembre 1995 (1995-11-10)

## Description

La présente invention concerne un convertisseur pour moteur ou transformateur électrique, par exemple un moteur asynchrone, synchrone, à aimants permanents ou continu, ce convertisseur comportant des cartes sur lesquelles sont montés des composants électroniques.

On entend par convertisseur (en anglais *inverter* ou *drive*) tout dispositif à semi-conducteurs statique, permettant le pilotage de moteurs électriques ou le changement de fréquence pour alimenter un transformateur électrique.

L'invention vise à proposer un nouveau convertisseur de ce type, qui soit compact, fiable et relativement peu coûteux à fabriquer.

Ce convertisseur se caractérise par le fait qu'il comporte un boîtier dans lequel sont disposées au moins trois cartes, dont une carte arrière, une carte avant et au moins une carte intermédiaire fixée à angle droit sur les cartes arrière et avant, avec des soudures assurant des liaisons électriques entre les cartes, au moins un composant électronique de puissance étant monté sur l'une des cartes, de préférence la carte arrière.

Avantageusement, le ou les composants électroniques de puissance sont reliés thermiquement à un radiateur.

Avantageusement, ce radiateur est constitué au moins partiellement par le boîtier logeant les cartes.

Avantageusement encore, le radiateur est réalisé d'un seul tenant avec le reste du boîtier, par moulage.

De préférence, la carte arrière et au moins une partie de la ou des cartes intermédiaires sont noyées dans une résine isolante électriquement, mais conductrice thermiquement, coulée à l'intérieur du boîtier.

Cette résine contribue à dissiper les calories et améliore la tenue mécanique des cartes.

Le montage particulier des cartes permet de gagner en compacité et en fiabilité et de simplifier la fabrication, puisque les liaisons entre les cartes peuvent être assurées par de simples soudures sans qu'il soit nécessaire d'utiliser des nappes de fils conducteurs ou d'autres moyens d'interliaison comme des fils ou des connecteurs indépendants.

Dans une réalisation préférée, le ou les composants électroniques de puissance sont montés sur la face arrière de la carte arrière et sont en contact thermique avec la face intérieure de la paroi arrière du boîtier.

Avantageusement, la face intérieure de la paroi arrière du boîtier comporte des reliefs agencés pour coopérer avec le ou les composants électroniques de puissance.

Toujours dans une réalisation préférée, le convertisseur comporte une deuxième carte intermédiaire, parallèle à la première, fixée à angle droit sur les cartes arrière et avant, avec des soudures assurant des liaisons électriques entre les cartes.

De préférence, l'une au moins des cartes avant, arrière et intermédiaire(s) comporte une fente et une autre desdites cartes avant, arrière et intermédiaire(s) comporte une languette agencée pour s'engager dans cette fente.

Avantageusement, la carte avant porte au moins un connecteur permettant d'assurer le raccordement électrique du convertisseur avec des fils électriques véhiculant des signaux de commande, ainsi que de préférence mais non nécessairement, un connecteur pour le raccordement de l'alimentation de puissance et un connecteur pour le raccordement au moteur ou au transformateur.

Avantageusement, la majorité des composants volumineux du convertisseur sont montés sur les faces des cartes qui sont tournées vers le centre du boîtier, ce qui permet de gagner en compacité.

De préférence, la résine coulée dans le boîtier arrive à affleurement de la carte avant, ce qui permet de rendre accessible à l'utilisateur tout connecteur monté sur la face extérieure de cette carte.

Le convertisseur selon l'invention permet de constituer aisément un module capable d'être rapporté sur un boîtier de raccordement électrique servant d'interface client, fixé par exemple sur un moteur électrique.

L'invention a encore pour objet un moteur électrique, caractérisé par le fait qu'il comporte un boîtier de raccordement fixé sur le carter du moteur et un convertisseur tel que défini plus haut.

Cette conception modulaire permet de remplacer aisément le convertisseur en cas de défaillance de l'électronique.

Il est également possible de fabriquer en grande série le convertisseur et de le monter sur différents boîtiers de raccordement, spécifiques chacun à un type de moteur, ces boîtiers de raccordement subissant les adaptations aux différents types de moteurs.

Avantageusement, le moteur comporte un joint isolant thermique entre le boîtier du convertisseur et le boîtier de raccordement électrique.

Ce joint thermique permet d'éviter qu'aux faibles vitesses de fonctionnement du moteur, pour lesquelles le ventilateur de refroidissement du moteur tourne relativement lentement, la chaleur dégagée par le moteur ne gagne par conduction le convertisseur et n'affecte son fonctionnement.

Dans une réalisation préférée, le boîtier du convertisseur sert de radiateur.

Dans ce cas, le boîtier comporte avantageusement, sur au moins une face, des ailettes se présentant sous la forme de nervures parallèles discontinues, créant des alignements d'ailettes dans deux directions perpendiculaires entre elles, l'air pouvant s'écouler entre les ailettes dans chacune de ces deux directions.

Cette disposition des ailettes permet de garantir un refroidissement par convection dans deux orientations différentes du convertisseur par rapport à la verticale.

De préférence, chaque ailette présente en section transversale une forme oblongue, avec deux faces planes principales opposées convergeant vers son sommet.

Cette géométrie permet de réaliser aisément des ailettes plus ou moins longues selon la puissance à dissiper.

Les ailettes sont alors avantageusement réalisées en utilisant un moule comportant un ou plusieurs tiroirs interchangeables choisis selon la longueur à donner aux ailettes.

On évite ainsi d'avoir à utiliser un moule spécifique pour réaliser différentes longueurs d'ailettes, puisque ces dernières peuvent être réalisées à la longueur voulue en choisissant le ou les tiroirs adaptés.

De plus, les ailettes restent relativement courtes et refroidissent assez rapidement, ce qui autorise des cadences relativement élevées en moulage par injection.

D'autres caractéristiques et avantages de la présente invention ressortiront à la lecture de la description détaillée qui va suivre, d'exemples de réalisation non limitatifs, et à l'examen du dessin annexé, sur lequel :
- la figure 1 est une vue schématique et partielle, en coupe axiale, d'un convertisseur conforme à l'invention et d'un boîtier de raccordement électrique,
- la figure 2 représente isolément, en vue de côté, les cartes du convertisseur,
- la figure 3 est une vue de dessus selon la flèche III de la figure 2,
- la figure 4 est une vue partielle et schématique des ailettes de refroidissement réalisées sur la face arrière du boîtier du convertisseur, et
- la figure 5 représente un convertisseur muni de pattes de fixation murale et d'un boîtier de raccordement électrique indépendant.

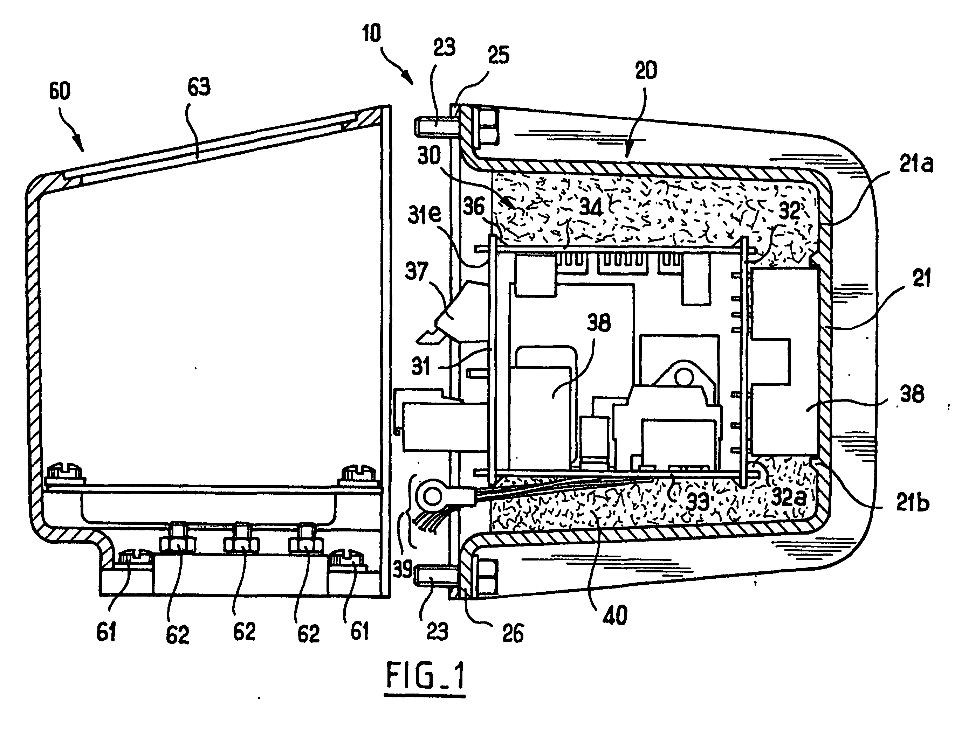

On a représenté sur la figure 1 un convertisseur 10 conforme à l'invention, de puissance comprise entre 0,25 et 15 kW par exemple, comportant un boîtier métallique 20, ouvert à l'avant, réalisé par moulage par injection en aluminium, faisant office de radiateur, avec à l'intérieur de ce boîtier un ensemble électronique 30 de quatre cartes électroniques, à savoir une carte avant 31, une carte arrière 32 et deux cartes intermédiaires 33 et 34.

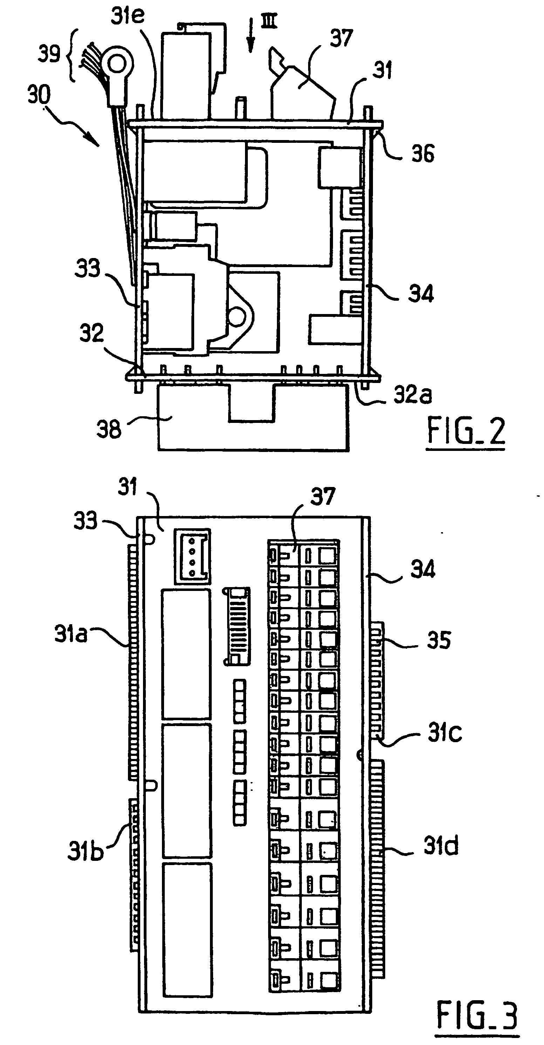

On a représenté isolément sur la figure 2 l'ensemble électronique 30.

Les cartes avant 31 et arrière 32 sont parallèles et sont perpendiculaires aux cartes intermédiaires 33 et 34.

Les cartes intermédiaires 33 et 34 sont pourvues, au voisinage de leurs extrémités adjacentes aux cartes avant 31 et arrière 32, de fentes et les cartes avant 31 et arrière 32 sont pourvues de languettes de connexion conformées pour s'engager dans les fentes précitées.

Les languettes de connexion de la carte avant 31 portent les références 31a à 31d sur la figure 3.

Des pistes électriques 35 sont réalisées sur les languettes de connexion, ces pistes formant partie intégrante du circuit imprimé de la carte.

Ces pistes électriques sont reliées électriquement aux circuits imprimés des cartes comportant les fentes.

Des ponts de soudure 36 assurent la continuité électrique entre les différentes cartes 31 à 34 au niveau des languettes et des fentes associées ainsi que l'immobilisation des cartes entre elles.

On peut ainsi réaliser le circuit électrique du convertisseur sans avoir à utiliser de nappes souples de fils conducteurs pour relier les différentes cartes, contrairement à ce qui est le cas dans les convertisseurs connus.

Dans l'exemple de réalisation décrit, ce sont les cartes avant 31 et arrière 32 qui comportent des languettes à engager dans des fentes correspondantes prévues sur les cartes intermédiaires 33 et 34.

On peut bien entendu, sans sortir du cadre de l'invention, munir les cartes intermédiaires 33 et 34 de languettes et les cartes avant 31 et arrière 32 de fentes pour recevoir ces languettes.

On peut encore munir l'une des cartes intermédiaires 33 et 34 de languettes et l'autre de fentes.

Dans l'exemple de réalisation décrit, la carte avant 31 comporte sur sa face extérieure 31e une barrette de connecteurs 37, laquelle permet de relier le convertisseur à des lignes électriques véhiculant par exemple des signaux de commande pour faire tourner le moteur plus ou moins rapidement.

Des composants électroniques de puissance 38 sont montés sur la face arrière 32a de la carte arrière 32.

Ces composants électroniques de puissance 38 sont plaqués contre la face intérieure 21a de la paroi arrière 21 du boîtier 20, de manière à transmettre par conduction l'énergie thermique au boîtier 20.

On remarquera à l'examen des figures 1 et 2 qu'une grande partie des composants volumineux 58 du convertisseur sont montés sur les faces des cartes intermédiaires 33 et 34 tournées vers le centre du boîtier 20, ce qui permet de réaliser le convertisseur de manière particulièrement compacte.

Dans l'exemple de réalisation décrit, le convertisseur comporte des câbles électriques 39 reliés à l'une des cartes et s'étendant hors du boîtier 20.

Une résine électriquement isolante 40 mais thermiquement conductrice est coulée à l'intérieur du boîtier 20 pour protéger l'ensemble électronique 30 de l'humidité, des vibrations et parfaire l'isolation électrique.

La résine 40 vient à affleurement de la carte avant 31, comme on peut le voir sur la figure 1.

La face intérieure 21a de la paroi arrière 21 du boîtier 20 comporte, comme représenté, des reliefs 21b assurant un positionnement prédéterminé de l'ensemble électrique 30 dans le boîtier 20 avant que la résine 40 ne soit coulée.

Ces reliefs 21b sont agencés pour coopérer avec les composants électroniques de puissance 38.

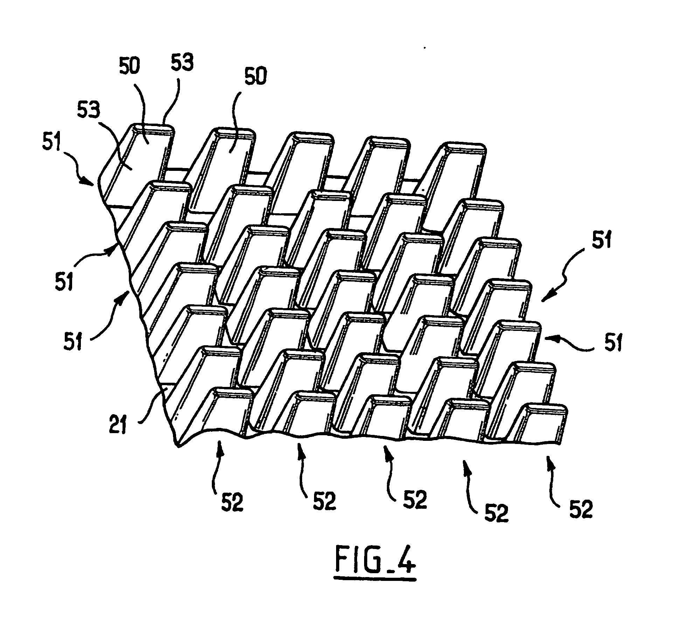

Le boîtier 20 comporte avantageusement, sur la face extérieure de sa paroi arrière 21, une pluralité d'ailettes 50 que l'on a représentées schématiquement sur la figure 4.

Ces ailettes 50 n'ont pas été représentées sur la figure 1 dans un souci de clarté du dessin.

Les ailettes 50 sont disposées selon des rangées parallèles 51.

Au sein de chaque rangée 51, les ailettes 50 sont disposées à intervalle régulier, de sorte qu'elles constituent des alignements 52 perpendiculaires aux rangées 51.

Chaque ailette 50 présente une forme allongée dans une direction perpendiculaire au plan de la paroi arrière 21, avec en section transversale une forme oblongue de grand axe parallèle aux rangées 51.

On remarquera à l'examen de la figure 4 que l'air peut circuler entre deux rangées 51 consécutives ainsi qu'entre les alignements 52, ce qui permet le montage du convertisseur soit avec les rangées 51 horizontales, le boîtier 20 étant alors orienté comme représenté sur la figure 1, c'est-à-dire avec les cartes intermédiaires 33 et 34 horizontales, soit en variante avec les rangées 51 verticales, les cartes intermédiaires 33 et 34 étant alors verticales.

Dans les deux cas, les mouvements de convection verticaux de l'air entre les ailettes 50 ne sont pas entravés.

Chaque ailette 50 comporte deux faces planes principales opposées 53 qui convergent avec un angle de quelques degrés vers l'extrémité libre de l'ailette.

Selon la puissance thermique à dissiper, les ailettes 50 sont réalisées plus ou moins longues.

Les ailettes 50 sont réalisées dans l'exemple décrit d'un seul tenant en aluminium avec le reste du boîtier, au moyen d'un moule comportant un tiroir qui est interchangeable et qui est choisi de manière à réaliser des ailettes plus ou moins longues.

On peut ainsi, au moyen d'un même moule, réaliser un boîtier ayant des ailettes dont la longueur est adaptée à la puissance à dissiper.

La forme générale aplatie de chaque ailette 50 facilite le nettoyage du radiateur par rapport aux radiateurs connus comportant une pluralité de troncs de cônes, car les faces principales planes des ailettes offrent une surface de contact relativement importante avec un organe de nettoyage déplacé parallèlement aux rangées 51.

Dans l'exemple de la figure 1, le convertisseur 10 est assemblé avec un boîtier de raccordement électrique 60 fixé sur la partie supérieure du carter d'un moteur électrique.

Le boîtier 20 est positionné de manière à se trouver dans le flux d'air de refroidissement généré par le ventilateur du moteur.

Le boîtier de raccordement 60 comporte des boulons 61 servant à la fixation sur le moteur ainsi que des bornes de connexion 62 reliées au moteur.

Les fils 39 du convertisseur 10 sont à relier à ces bornes de connexion 62.

Le boîtier 60 comporte en partie supérieure une fenêtre 63 permettant à un utilisateur d'accéder aisément aux conducteurs électriques 39, aux bornes de connexion 62 ainsi qu'à la barrette de connecteurs 37.

Des passages garnis de joints d'étanchéité sont prévus sur le boîtier 60, de façon connue en soi, pour le passage des fils d'alimentation et de commande du convertisseur 10.

On n'a pas représenté ces passages dans un souci de clarté du dessin.

Le boîtier 20 comporte à l'avant, dans l'exemple de réalisation décrit, une bride 26 pourvue d'une pluralité de vis de fixation 23 servant au montage sur le boîtier de raccordement 60.

Un joint isolant thermique 25 est placé sur le pourtour de la bride 26 pour constituer une barrière thermique tendant à s'opposer à la transmission de chaleur du boîtier de raccordement 60 vers le boîtier 20.

Cette barrière thermique est particulièrement utile lors des bas régimes de fonctionnement du moteur, c'est-à-dire lorsque le ventilateur entraîné par l'arbre du moteur tourne avec une faible vitesse.

La présence du joint 25 freine alors la transmission par conduction de la chaleur en provenance du carter du moteur vers le boîtier 20.

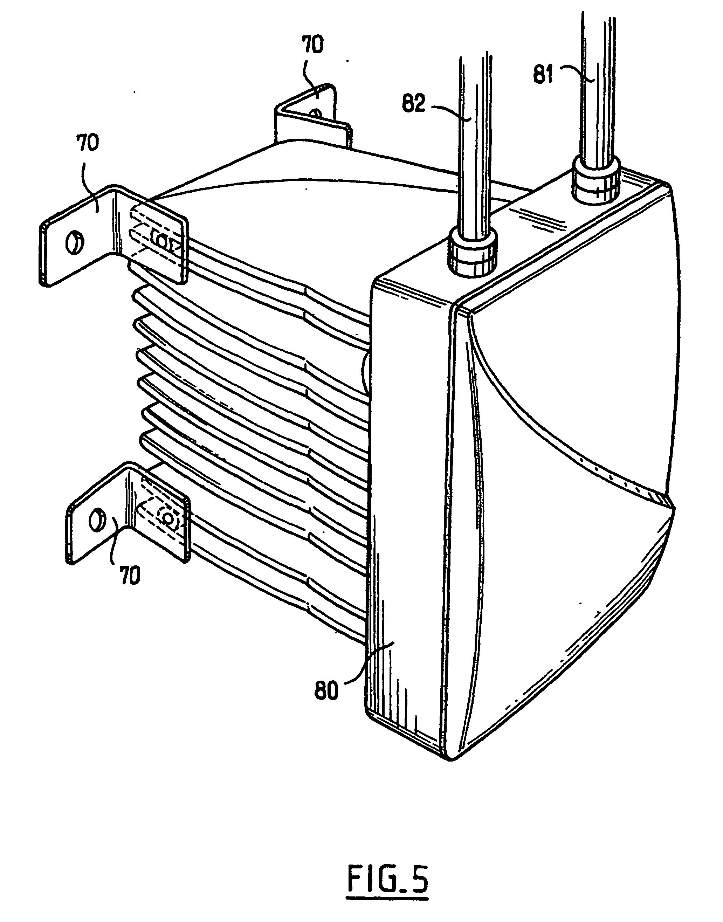

L'ensemble électronique 30 permet la réalisation d'un module qui peut être assemblé avec un boîtier de raccordement 60 fixé sur un moteur, comme cela vient d'être décrit, ou en variante être logé dans un boîtier indépendant, comme cela va maintenant être décrit en référence à la figure 5.

Sur cette figure, des pattes de fixation murale 70 sont prévues sur les parois latérales du boîtier logeant l'ensemble électronique 30.

Dans une variante non représentée, ces pattes sont prévues sur la face arrière dudit boîtier.

Un boîtier de raccordement électrique 80 est fixé sur l'avant du boîtier logeant l'ensemble électronique 30.

On a représenté des câbles d'arrivée 81 et de départ 82 connectés à l'ensemble électronique 30 à l'intérieur du boîtier de raccordement 80.

Si la puissance électrique à dissiper l'exige, le boîtier du convertisseur peut comporter des ailettes telles que celles décrites en référence à la figure 4.

Bien entendu, l'invention n'est pas limitée aux exemples de réalisation qui viennent d'être décrits.

On peut notamment réaliser l'ensemble électronique 30 avec une carte avant, une carte arrière et une seule carte intermédiaire, si le nombre de composants électroniques ne nécessite pas l'utilisation d'une deuxième carte intermédiaire.

On peut encore modifier l'orientation des cartes par rapport aux parois du boîtier.

On peut encore intercaler, entre le boîtier de raccordement électrique 60 et le boîtier 20, un module intermédiaire servant par exemple à dissiper de l'énergie thermique.

Un ou plusieurs composants électroniques de puissance peuvent encore être montés sur l'une des cartes intermédiaires et être reliés thermiquement au boîtier logeant l'ensemble électronique.

Le moteur peut être remplacé par un transformateur, par exemple un transformateur logé dans le carter d'un moteur et dont le primaire et le secondaire sont bobinés sur des circuits magnétiques analogues à ceux d'un stator et d'un rotor.

## Revendications

1. Convertisseur pour moteur ou transformateur électrique, comportant des cartes sur lesquelles sont montés des composants, **caractérisé par le fait qu'**il comporte un boîtier (20) dans lequel sont disposées au moins trois cartes, dont une carte arrière (32), une carte avant (31) et au moins une carte intermédiaire (33, 34) fixée à angle droit sur les cartes arrière et avant, avec des soudures (36) assurant des liaisons électriques entre les cartes, au moins un composant électronique de puissance (38) étant monté sur l'une des cartes, de préférence la carte arrière.

2. Convertisseur selon la revendication 1, **caractérisé par le fait que** le ou les composants électroniques de puissance (38) sont reliés thermiquement à un radiateur.

3. Convertisseur selon la revendication précédente, **caractérisé par le fait que** le radiateur est constitué au moins partiellement par le boîtier (20) logeant les cartes.

4. Convertisseur selon la revendication précédente, **caractérisé par le fait que** le radiateur est réalisé d'un seul tenant avec le reste du boîtier (20), par moulage.

5. Convertisseur selon l'une quelconque des revendications précédentes, **caractérisé par le fait que** la carte arrière (32) et au moins une partie de la ou des cartes intermédiaires (33, 34) sont noyées dans une résine électriquement isolante (40) mais thermiquement conductrice, coulée à l'intérieur du boîtier.

6. Convertisseur selon l'une quelconque des revendications précédentes, **caractérisé par le fait que** le ou les composants électroniques de puissance (38) sont montés sur la face arrière (32a) de la carte arrière (32) et sont en contact thermique avec la face intérieure (21a) de la paroi arrière (21) du boîtier (20).

7. Convertisseur selon la revendication précédente, **caractérisé par le fait que** la face intérieure (21a) de la paroi arrière (21) du boîtier (20) comporte des reliefs (21b) agencés pour coopérer avec le ou les composants électroniques de puissance (38).

8. Convertisseur selon l'une quelconque des revendications précédentes, **caractérisé par le fait qu'**il comporte une deuxième carte intermédiaire (34), parallèle à la première (33), fixée à angle droit sur les cartes arrière (32) et avant (31), avec des soudures (36) assurant des liaisons électriques entre les cartes.

9. Convertisseur selon l'une quelconque des revendications précédentes, **caractérisé par le fait que** la carte avant (31) porte au moins un connecteur permettant d'assurer le raccordement électrique du convertisseur avec des fils électriques véhiculant des signaux de commande, et de préférence un connecteur pour l'alimentation de puissance et un connecteur pour le raccordement au moteur.

10. Convertisseur selon l'une quelconque des revendications précédentes, **caractérisé par le fait que** la majorité des composants volumineux (58) du convertisseur sont montés sur les faces des cartes (33, 34) tournées vers le centre du boîtier.

11. Convertisseur selon l'une quelconque des revendications précédentes, **caractérisé par le fait que** l'une au moins des cartes avant, arrière et intermédiaire (s) comporte une fente et une autre desdites cartes avant, arrière et intermédiaire (s) comporte une languette (35) agencée pour s'engager dans cette fente.

12. Convertisseur selon l'une quelconque des revendications précédentes, **caractérisé par le fait que** le radiateur comporte sur au moins une face des ailettes (50) se présentant sous la forme de nervures parallèles discontinues, créant des alignements d'ailettes dans deux directions perpendiculaires entre elles, l'air pouvant s'écouler entre les ailettes dans chacune de ces deux directions.

13. Convertisseur selon la revendication précédente, **caractérisé par le fait que** chaque ailette (50) présente en section transversale une forme oblongue, avec des faces planes principales opposées (53) convergeant vers son sommet.

14. Moteur électrique, **caractérisé par le fait qu'**il comporte un boîtier de raccordement électrique (60) fixé sur le carter du moteur et un convertisseur tel que défini dans l'une quelconque des revendications précédentes.

15. Moteur électrique selon la revendication précédente, **caractérisé par le fait qu'**il comporte un joint isolant thermique (25) entre le boîtier du convertisseur et le boîtier de raccordement (60).

16. Procédé de fabrication d'un boîtier de convertisseur tel que défini dans la revendication 12, **caractérisé par le fait que** l'on utilise un moule comportant un ou plusieurs tiroirs interchangeables et choisis selon la longueur à donner aux ailettes (50).

## Patentansprüche

1. Konverter für einen elektrischen Motor oder Transformator, mit Karten, auf denen Komponenten befestigt sind, **gekennzeichnet durch** ein Gehäuse (20), in dem wenigstens drei Karten angeordnet sind, darunter eine hintere Karte (32), eine vordere Karte (31) und wenigstens eine mittlere Karte (33, 34), die in einem rechten Winkel zu der hinteren und der vorderen Karte befestigt ist, mit Lötstellen (36), die elektrische Verbindungen zwischen den Karten herstellen, wobei wenigstens eine elektronische Leistungskomponente (38) auf einer der Karten, vorzugsweise der hinteren Karte, befestigt ist.

2. Konverter nach Anspruch 1, **dadurch gekennzeichnet, daß** die elektronische(n) Leistungskomponente(n) (38) thermisch an ein Heizgerät angebunden ist/sind.

3. Konverter nach dem vorstehenden Anspruch, **dadurch gekennzeichnet, daß** das Heizgerät wenigstens teilweise durch das Gehäuse (20) gebildet wird, das die Karten enthält.

4. Konverter nach dem vorstehenden Anspruch, **dadurch gekennzeichnet, daß** das Heizgerät durch Formguß in einem Stück mit dem Rest des Gehäuses (20) ausgebildet ist.

5. Konverter nach einem der vorstehenden Ansprüche, **dadurch gekennzeichnet, daß** die hintere Karte (32) und wenigstens ein Teil der mittlere(n) Karte(n) (33, 34) in einem elektrisch isolierenden aber thermisch leitfähigen Harz (40) eingebettet sind, das in das Innere des Gehäuses gegossen wurde.

6. Konverter nach einem der vorstehenden Ansprüche, **dadurch gekennzeichnet, daß** die elektronische(n) Leistungskomponente(n) (38) auf der hinteren Seite (32a) der hinteren Karte (32) befestigt sind und in thermischem Kontakt mit der Innenseite (21a) der hinteren Wand (21) des Gehäuses (20) stehen.

7. Konverter nach dem vorstehenden Anspruch, **dadurch gekennzeichnet, daß** die Innenseite (21a) der hinteren Wand (21) des Gehäuses (20) Vorsprünge (21b) aufweist, die dazu ausgelegt sind, mit der/den elektronische(n) Leistungskomponente(n) (38) zusammenzuwirken.

8. Konverter nach einem der vorstehenden Ansprüche, **dadurch gekennzeichnet, daß** er eine zweite mittlere Karte (34), parallel zu der ersten (33) aufweist, die in rechtem Winkel zu der hinteren (32) und der vorderen (31) Karte steht, mit Lötverbindungen (36), die elektrische Verbindungen zwischen den Karten herstellen.

9. Konverter nach einem der vorstehenden Ansprüche, **dadurch gekennzeichnet, daß** die vordere Karte (31) wenigstens ein Verbindungselement aufweist, das die Herstellung einer elektrischen Verbindung des Konverters mit elektrischen Leitungen erlaubt, die Befehlssignale übertragen, und vorzugsweise mit einem Anschluß zur Leistungsversorgung und einem Anschluß zur Verbindungsherstellung mit einem Motor.

10. Konverter nach einem der vorstehenden Ansprüche, **dadurch gekennzeichnet, daß** die Mehrzahl der voluminösen Komponenten (58) des Konverters auf den Seiten der Karten (33, 34) befestigt sind, die zur Mitte des Gehäuses gerichtet sind.

11. Konverter nach einem der vorstehenden Ansprüche, **dadurch gekennzeichnet, daß** wenigstens eine der vorderen, hinteren und mittlere(n) Karte(n) einen Schlitz aufweist, und eine andere der vorderen, hinteren und mittleren Karte(n) eine Lasche (35) aufweist, die dazu ausgelegt ist, in den Schlitz einzugreifen.

12. Konverter nach einem der vorstehenden Ansprüche, **dadurch gekennzeichnet, daß** das Heizgerät auf wenigstens einer Seite Stege (50) aufweist, die in Form von parallelen, diskontinuierlichen Rippen vorliegen und zwischen sich fluchtende Stegverbindungslinien in zwei senkrechten Richtungen schaffen, so daß Luft zwischen den Stegen in jeder der zwei Richtungen strömen kann.

13. Konverter nach dem vorstehenden Anspruch, **dadurch gekennzeichnet, daß** jeder Steg (50) eine längliche Querschnittsform aufweist, mit ebenen entgegengesetzten Hauptseiten (53), die zu seiner Spitze hin konvergieren.

14. Elektromotor, **dadurch gekennzeichnet, daß** er ein Gehäuse zur elektrischen Verbindungsherstellung (60), das an dem Motorenkasten befestigt ist, und einen Konverter gemäß einem der vorstehenden Ansprüche aufweist.

15. Elektromotor nach dem vorstehenden Anspruch, **dadurch gekennzeichnet, daß** er eine thermisch isolierende Verbindung (25) zwischen dem Konvertergehäuse und dem Verbindungsgehäuse (60) aufweist.

16. Verfahren zur Herstellung eines Gehäuses für einen Konverter gemäß Anspruch 12, **dadurch gekennzeichnet, daß** eine Gußform mit einem oder mehreren austauschbaren und gemäß der durch die Stege (50) vorgegebenen Länge ausgewählten Einschubteilen verwendet wird.

## Claims

1. Converter for an electric motor or transformer, comprising cards on which components are fitted, **characterised by** the fact that it comprises a box (20) in which at least three cards are arranged, including a rear card (32), a front card (31) and at least one intermediate card (33, 34) fixed at a right angle to the rear and front cards, with welds (36) providing the electrical connections between the cards, at least one electronic power component (38) being fitted on one of the cards, preferably the rear card.

2. Converter according to claim 1, **characterised by** the fact that the electronic power component or components (38) are thermally connected to a radiator.

3. Converter according to the preceding claim, **characterised by** the fact that the radiator is formed, at least in part, by the box (20) accommodating the cards.

4. Converter according to the preceding claim, **characterised by** the fact that the radiator is produced in one piece with the rest of the box (20) by moulding.

5. Converter according to any one of the preceding claims, **characterised by** the fact that the rear card (32) and at least a portion of the intermediate card or cards (33, 34) are steeped in a resin (40) that is electrically insulating, but thermally conductive, poured inside the box.

6. Converter according to any one of the preceding claims, **characterised by** the fact that the electronic power component or components (38) are fitted on the rear face (32a) of the rear card (32) and are in thermal contact with the inner face (21a) of the rear wall (21) of the box (20).

7. Converter according to the preceding claim, **characterised by** the fact that the inner face (21a) of the rear wall (21) of the box (20) comprises raised portions (21b) that are configured for cooperating with the electronic power component or components (38).

8. Converter according to any one of the preceding claims, **characterised by** the fact that it comprises a second intermediate card (34), which is parallel to the first intermediate card (33) and fixed at a right angle to the rear card (32) and front card (31), with welds (36) providing electrical connections between the cards.

9. Converter according to any one of the preceding claims, **characterised by** the fact that the front card (31) has at least one connector allowing the converter to be electrically connected to the electrical wires conveying control signals, and preferably a connector for supplying power and a connector for connecting to the motor.

10. Converter according to any one of the preceding claims, **characterised by** the fact that most of the bulky components (58) of the converter are fitted on the faces of the cards (33, 34) that are turned toward the centre of the box.

11. Converter according to any one of the preceding claims, **characterised by** the fact that at least one of the front, rear and intermediate cards comprises a slot and another of said front, rear and intermediate cards comprises a strip (35) configured for engaging with this slot.

12. Converter according to any one of the preceding claims, **characterised by** the fact that the radiator comprises on at least one face fins (50) in the form of intermittent parallel ribs, creating fin alignments in two mutually perpendicular directions, air being able to flow between the fins in each of these two directions.

13. Converter according to the preceding claim, **characterised by** the fact that each fin (50) has in cross section an oblong shape, with opposing principal plane faces (53) converging toward its peak.

14. Electric motor, **characterised by** the fact that it comprises an electrical connection box (60) fixed to the case of the motor and a converter as defined in any one of the preceding claims.

15. Electric motor according to the preceding claim, **characterised by** the fact that it comprises a thermal insulation joint (25) between the box of the converter and the connection box (60).

16. Method for producing a converter box as defined in claim 12, **characterised by** the fact that a mould comprising one or more slide elements that are interchangeable and selected according to the length to be imparted to the fins (50) is used.
